(19) Europäisches Patentamt
European Patent Office
Office européen des brevets

(11) **EP 4 123 733 A1**

(12) **EUROPEAN PATENT APPLICATION**
published in accordance with Art. 153(4) EPC

(43) Date of publication:
**25.01.2023 Bulletin 2023/04**

(21) Application number: **21771062.3**

(22) Date of filing: **09.03.2021**

(51) International Patent Classification (IPC):
*H01L 35/14* [(2006.01)]   *C01B 33/06* [(2006.01)]
*H01L 35/22* [(2006.01)]   *H01L 35/26* [(2006.01)]

(52) Cooperative Patent Classification (CPC):
**C01B 33/06; H01L 35/14; H01L 35/22; H01L 35/26**

(86) International application number:
**PCT/JP2021/009217**

(87) International publication number:
**WO 2021/187225 (23.09.2021 Gazette 2021/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.03.2020 JP 2020045332**

(71) Applicant: **Mitsubishi Materials Corporation
Tokyo 100-8117 (JP)**

(72) Inventor: **NAKADA, Yoshinobu
Saitama-shi, Saitama 330-8508 (JP)**

(74) Representative: **Hoffmann Eitle
Patent- und Rechtsanwälte PartmbB
Arabellastraße 30
81925 München (DE)**

(54) **THERMOELECTRIC CONVERSION MATERIAL, THERMOELECTRIC CONVERSION ELEMENT, AND THERMOELECTRIC CONVERSION MODULE**

(57)   There is provided a thermoelectric conversion material in which a first layer containing $Mg_2Si_xSn_{1-x}$ (here, $0 < x < 1$) is directly joined to a second layer containing $Mg_2Si_ySn_{1-y}$ (here, $0 < y < 1$), where $x/y$ is set within a range of more than 1.0 and less than 2.0. There is also provided a thermoelectric conversion element including the thermoelectric conversion material and electrodes each joined to one surface and the other surface of the thermoelectric conversion material. There is also provided a thermoelectric conversion module including terminals each joined to the electrodes of the thermoelectric conversion element.

FIG. 1

**Description**

TECHNICAL FIELD

The present invention relates to a thermoelectric conversion material having excellent thermoelectric conversion efficiency, a thermoelectric conversion element, and a thermoelectric conversion module.
Priority is claimed on Japanese Patent Application No. 2020-045332, filed March 16, 2020, the content of which is incorporated herein by reference.

BACKGROUND ART

A thermoelectric conversion element made of a thermoelectric conversion material is an electronic element that enables mutual conversion between heat and electricity by the Seebeck effect and the Peltier effect. The Seebeck effect is a phenomenon in which an electromotive force is generated when a temperature difference is generated between both ends of the thermoelectric conversion material, and the thermal energy is converted into electric energy. Such electromotive force is determined by the characteristics of the thermoelectric conversion material. In recent years, thermoelectric power generation utilizing this effect has been actively developed (see, for example, Patent Document 1).
The above-described thermoelectric conversion element has a structure in which electrodes are each formed on one end side and the other end side of the thermoelectric conversion material.
As an indicator that indicates the characteristics of such a thermoelectric conversion element (a thermoelectric conversion material), for example, a power factor (PF) represented by Expression (1) or a dimensionless figure of merit represented by Expression (2) (ZT) is used.

$$PF = S^2\sigma \ ... \ (1)$$

Here, S: Seebeck coefficient (V/K), $\sigma$: electrical conductivity (S/m)

$$ZT = S^2\sigma T/\kappa \ ... \ (2)$$

(Here, T = absolute temperature (K), $\kappa$ = thermal conductivity (W/(m $\times$ K))
Here, as can be seen from Expressions (1) and (2), the thermoelectric conversion performance is greatly affected by the temperature.
The temperature at which the performance of a thermoelectric conversion element is maximized differs greatly depending on the constituent materials.
Therefore, in a case where a thermoelectric conversion element is manufactured from one kind of constituent material, the total of power generation amount due to the temperature distribution generated between the high temperature side and the low temperature side is the power generation amount of the thermoelectric conversion. As a result, there is a problem that even in a case where a thermoelectric conversion element is formed using a constituent material having a high dimensionless figure of merit (ZT), the power generation amount in a case of being viewed as a whole is not always high because the thermoelectric conversion efficiency on the low temperature side is low.
In order to improve the decrease in thermoelectric conversion efficiency due to the temperature distribution in one thermoelectric conversion element, there is known a thermoelectric conversion element having a multilayer structure, in which two or more different constituent materials are stacked. In this thermoelectric conversion element having a multilayer structure, a constituent material of which thermoelectric characteristics are improved in a high temperature state is arranged on the high temperature side, and a constituent material of which thermoelectric characteristics are improved in a low temperature state is arranged on the low temperature side, and these constituent materials are joined via a conductive joining layer.
However, in the above-described thermoelectric conversion element having a multilayer structure, two or more different constituent materials are joined via a conductive joining layer, and there is also a problem that peeling easily occurs in the joining portion due to the difference in the coefficient of thermal expansion between the joining layer and the constituent material. In addition, the structure is very complicated because electrodes are arranged at the interface of different constituent materials, and electricity is extracted from each constituent material.
Therefore, Patent Document 2 proposes a thermoelectric conversion material having a structure in which a first layer made of $Mg_2Si$ is directly joined to a second layer made of $Mg_2Si_xSn_{1-x}$ (here, x is 0 or more and less than 1).
The thermoelectric conversion material disclosed in Patent Document 2 has the same crystal structure at the joining surface between a first layer and a second layer, which is a structure in which a part of Si is replaced with Sn.

The difference in coefficient of thermal expansion is small between the first layer and the second layer, and it is possible to suppress the occurrence of peeling and cracking on the joining surface due to the temperature difference.

[Citation List]

[Patent Documents]

[Patent Document 1]
Published Japanese Translation No. 2012-533972 of the PCT International Publication
[Patent Document 2]
Japanese Unexamined Patent Application, First Publication No. 2017-175122

SUMMARY OF INVENTION

Technical Problem

By the way, in a thermoelectric conversion element having a multilayer structure in which two or more different constituent materials are stacked, the conductivity is restricted by the constituent material having the highest electric resistance, and there is a possibility that the power generation efficiency cannot be sufficiently improved.

Further, since the Mg-Si-Sn-based material is a brittle material, cracking and the like are likely to occur due to the difference in the coefficient of thermal expansion. Therefore, depending on the usage environment, it is required to further reduce the difference in the coefficient of thermal expansion between the constituent materials to be stacked.

The present invention has been made in consideration of the above-described circumstances, an object of the present invention is to provide a thermoelectric conversion material that prevents cracking of a thermoelectric element and has excellent thermoelectric conversion efficiency, a thermoelectric conversion element, and a thermoelectric conversion module.

Solution to Problem

In order to solve the above problems, a thermoelectric conversion material of the present invention is characterized by the thermoelectric conversion material that a first layer containing $Mg_2Si_xSn_{1-x}$ (here, $0 < x < 1$) is directly joined to a second layer containing $Mg_2Si_ySn_{1-y}$ (here, $0 < y < 1$), where $x/y$ is set within a range of more than 1.0 and less than 2.0.

According to the thermoelectric conversion material of the present invention, by using a thermoelectric conversion material in which the first layer and the second layer, having mutually different temperature regions where the thermoelectric characteristics are improved, are directly joined, the thermoelectric characteristics of each of the first layer and the second layer are maximized, for example, by grounding one surface of the first layer on the high temperature environment side and another surface of the second layer on the low temperature environment side. As a result, it is possible to significantly improve the thermoelectric power generation output and the thermoelectric power conversion efficiency (power generation efficiency) as compared with a thermoelectric conversion material made of a material having a single composition.

In addition, according to the thermoelectric conversion material of the present invention, a first layer containing $Mg_2Si_xSn_{1-x}$ (here, $0 < x < 1$) is directly joined to a second layer containing $Mg_2Si_ySn_{1-y}$ (here, $0 < y < 1$), where $x/y$ is set within a range of more than 1.0 and less than 2.0. As a result, both the first layer and the second layer are formed of an Mg-Si-Sn material, and the electric resistance and the coefficient of thermal expansion are extremely close to each other. For this reason, it is possible to suppress an increase in electric resistance, and it is possible to sufficiently improve the power generation efficiency. In addition, the difference in the coefficient of thermal expansion is small, the occurrence of cracking due to the temperature difference can be suppressed, and the stable use is possible.

Here, in the thermoelectric conversion material of the present invention, at least one or both of the first layer and the second layer contains boride, in addition to $Mg_2Si_xSn_{1-x}$ constituting the first layer and $Mg_2Si_ySn_{1-y}$ constituting the second layer, where the boride preferably contains one or two or more metals selected from the group consisting of titanium, zirconium, and hafnium.

In this case, the boride aggregates at the crystal grain boundary of Mg-Si-Sn to improve the electrical conductivity, and it is possible to further improve the power factor (PF), which is one of the indicators of the thermoelectric characteristics. For example, the electrical conductivities of $TiB_2$, $ZrB_2$, and $HfB_2$ are each $1.11E7\ \Omega^{-1}m^{-1}$, $1.03E7\ \Omega^{-1}m^{-1}$, and $0.944E7\ \Omega^{-1}m^{-1}$.

Further, since the boride contains one or two or more kinds of metals selected from the group consisting of titanium, zirconium, and hafnium, it is possible to suppress the oxidation of magnesium and improve the oxidation resistance.

Further, since the above-described boride is relatively hard, it is possible to improve the hardness of the thermoelectric conversion material.

Further, in the thermoelectric conversion material of the present invention, the boride is preferably one or two or more selected from the group consisting of $TiB_2$, $ZrB_2$, and $HfB_2$.

In this case, since the boride is one or two or more borides selected from the group consisting of $TiB_2$, $ZrB_2$, and $HfB_2$, it is possible to reliably improve the thermoelectric characteristics, oxidation resistance, and mechanical strength of the thermoelectric conversion material.

Further, in the thermoelectric conversion material of the present invention, it is preferable that the total amount of the boride with respect to the thermoelectric conversion material is set within a range of 0.5 mass% or more and 15 mass% or less.

In this case, since the total amount of the boride is set within a range of 0.5 mass% or more and 15 mass% or less, it is possible to sufficiently improve the thermoelectric characteristics, oxidation resistance, and mechanical strength of the thermoelectric conversion material.

Further, in the thermoelectric conversion material of the present invention, at least one or both of the first layer and the second layer preferably contains aluminum, in addition to $Mg_2Si_xSn_{1-x}$, constituting the first layer and $Mg_2Si_ySn_{1-y}$ constituting the second layer.

In this case, since at least one or both of $Mg_2Si_xSn_{1-x}$ constituting the first layer and $Mg_2Si_ySn_{1-y}$ constituting the second layer contains aluminum, aluminum can suppress the infiltration of oxygen in the atmosphere into the inside of thermoelectric conversion material. As a result, the decomposition and oxidation of the thermoelectric conversion material are suppressed, and the durability in a case of being used under high temperature conditions can be improved.

Here, in the thermoelectric conversion material of the present invention, it is preferable that the amount of the aluminum with respect to the thermoelectric conversion material is set within a range of 0.3 mass% or more and 3 mass% or less.

In this case, aluminum can suppress the infiltration of oxygen in the atmosphere into the inside of thermoelectric conversion material, and the durability in a case of being used under high temperature conditions can be reliably improved.

The thermoelectric conversion element of the present invention is characterized by including the thermoelectric conversion material described above and electrodes each joined to one surface and the other surface of the thermoelectric conversion material.

According to the thermoelectric conversion element of this configuration, by using a thermoelectric conversion material in which the first layer and the second layer, having mutually different temperature regions where the thermoelectric characteristics are improved, are directly joined, the thermoelectric characteristics of each of the first layer and the second layer are maximized, for example, by placing one surface of the first layer in the high temperature environment and another surface of the second layer in the low temperature environment. As a result, it is possible to significantly improve the thermoelectric power generation output and the thermoelectric power conversion efficiency (power generation efficiency) as compared with a thermoelectric conversion element made of a material having a single composition.

The thermoelectric conversion module of the present invention is characterized by including the thermoelectric conversion element described above and terminals each joined to the electrodes of the thermoelectric conversion element.

According to the thermoelectric conversion module having this configuration, by using a thermoelectric conversion material in which the first layer and the second layer, having mutually different temperature regions where the thermoelectric characteristics are improved, are directly joined, the thermoelectric characteristics of each of the first layer and the second layer are maximized, for example, by placing one surface of the first layer in the high temperature environment and another surface of the second layer in the low temperature environment. As a result, it is possible to significantly improve the thermoelectric power generation output and the thermoelectric power conversion efficiency (power generation efficiency) as compared with a thermoelectric conversion device using the thermoelectric conversion material made of a material having a single composition.

Advantageous Effects of Invention

According to the present invention, it is possible to provide a thermoelectric conversion material having excellent thermoelectric conversion efficiency, a thermoelectric conversion element, and a thermoelectric conversion module.

BRIEF DESCRIPTION OF DRAWINGS

Fig. 1 is a cross-sectional view showing a thermoelectric conversion material, a thermoelectric conversion element, and a thermoelectric conversion module according to one embodiment of the present invention.

Fig. 2 is a flow chart of a method for producing a thermoelectric conversion material according to an embodiment of the present invention.

Fig. 3 is a cross-sectional view showing an example of a sintering device that is used in the method for producing a thermoelectric conversion material according to the embodiment of the present invention.

DESCRIPTION OF EMBODIMENTS

Hereinafter, a thermoelectric conversion material, a thermoelectric conversion element, and a thermoelectric conversion module according to an embodiment of the present invention will be described with reference to the attached drawings. Each embodiment to be described below is specifically described for a better understanding of the gist of the invention and does not limit the present invention unless otherwise specified. In addition, in the drawings used in the following description, for convenience, a portion that is a main part may be enlarged in some cases in order to make the features of the present invention easy to understand, and the dimensional ratio or the like of each component is not always the same as an actual one.

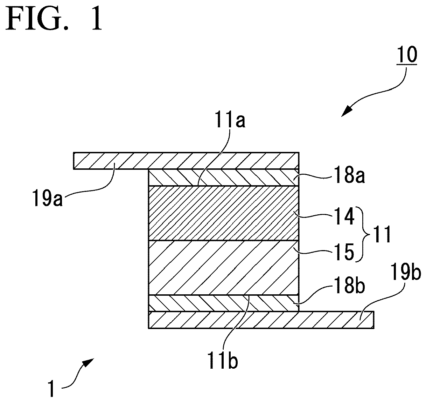

Fig. 1 shows a thermoelectric conversion material 11 according to an embodiment of the present invention, a thermoelectric conversion element 10 using the thermoelectric conversion material 11, and a thermoelectric conversion module 1.

The thermoelectric conversion element 10 includes a thermoelectric conversion material 11 according to the present embodiment, and electrodes 18a and 18b formed on one surface 11a and the other surface 11b of the thermoelectric conversion material 11.

Further, the thermoelectric conversion module 1 includes terminals 19a and 19b each joined to the electrodes 18a and 18b of the thermoelectric conversion element 10 described above.

Since thermoelectric conversion element 10 according to the present embodiment generates a temperature difference between one surface 11a and the other surface 11b of the thermoelectric conversion material 11, it can be used as a Seebeck element that generates a potential difference between the electrode 18a and the electrode 18b.

The thermoelectric conversion element 10 can be used as a Peltier element that generates a temperature difference between one surface 11a and the other surface 11b of the thermoelectric conversion material 11, by applying a voltage between the electrode 18a side and the electrode 18b. For example, in a case of allowing an electric current to flow between the electrode 18a side and the electrode 18b, it is possible to cool or heat one surface 11a or the other surface 11b of the thermoelectric conversion material 11.

Here, nickel, silver, cobalt, tungsten, molybdenum, or the like is used in the electrodes 18a and 18b. The electrodes 18a and 18b can be formed by energized sintering, plating, electrodeposition, or the like.

The terminals 19a and 19b are formed of a metal material having excellent conductivity, for example, a plate material such as copper or aluminum. In the present embodiment, a rolled aluminum plate is used. Further, the thermoelectric conversion element 10 (the electrodes 18a and 18b) can be joined to the terminals 19a and 19b by Ag wax, Ag plating, or the like.

In addition, the thermoelectric conversion material 11 according to the present embodiment has a structure in which a first layer 14 containing $Mg_2Si_xSn_{1-x}$ (here, $0 < x < 1$) is directly joined to a second layer 15 containing $Mg_2Si_ySn_{1-y}$ (here, $0 < y < 1$).

Both $Mg_2Si_xS_{n-x}$ constituting the first layer 14 and $Mg_2Si_ySn_{1-y}$ constituting the second layer 15 are made of an Mg-Si-Sn material. Here, the ratio of Si to Sn is different, and x/y is set within a range of more than 1.0 and less than 2.0.

x/y is preferably in a range of 1.2 to 1.8 and more preferably in a range of 1.3 to 1.6.

$Mg_2Si_xSn_{1-x}$ constituting the first layer 14 is contained in the first layer 14 preferably in an amount of 82 mass% or more and 100 mass% or less, and more preferably 85 mass% or more and 99.7% or less.

$Mg_2Si_ySn_{1-y}$ constituting the second layer 15 is contained in the second layer 15 preferably in an amount of 82 mass% or more and 100 mass% or less, and more preferably 85 mass% or more and 99.7% or less.

Here, $Mg_2Si_xSn_{1-x}$ (here, $0 < x < 1$) constituting the first layer 14 of the thermoelectric conversion material 11 is a material of which thermoelectric characteristics are improved in a high temperature region, for example, 300°C or higher, as compared with $Mg_2Si_ySn_{1-y}$ (here, $0 < y < 1$) constituting the second layer 15. On the other hand, $Mg_2Si_ySn_{1-y}$ (here, $0 < y < 1$) constituting the second layer 15 is a material of which thermoelectric characteristics (particularly, PF) are improved in a low temperature region, for example, less than 300°C, as compared with $Mg_2Si_xSn_{1-x}$ (here, $0 < x < 1$) constituting the first layer 14. Here, 300°C is used as a boundary as an example. However, the first layer having good characteristics at a temperature of 300°C or higher and the second layer having good characteristics at a temperature of less than 400°C (that is, two materials both having good characteristics at a temperature from 300°C to 400°C) may be combined.

As described above, by using the thermoelectric conversion material 11 in which the first layer 14 and the second layer 15 having mutually different temperature regions where the thermoelectric characteristics are improved are directly joined, the thermoelectric characteristics of each of the first layer 14 and the second layer 15 are maximized, for example, by placing the electrode 18a side of the first layer 14 in the high temperature environment and the electrode 18b side of the second layer 15 in the low temperature environment. As a result, it is possible to significantly improve the thermoelectric power generation output and the thermoelectric power conversion efficiency (power generation efficiency) as compared with a thermoelectric conversion material made of a material having a single composition.

It is noted that the thermoelectric conversion material 11 (the first layer 14 and the second layer 15) may be a non-doped material containing no dopant, or it may include, as the dopant, one or two or more selected from the group consisting of Li, Na, K, B, Ga, In, N, P, As, Sb, Bi, Ag, Cu, and Y.

Regarding the thermoelectric conversion material 11 (the first layer 14 and the second layer 15) of the present embodiment, antimony which is a pentavalent donor is added to obtain an n-type thermoelectric conversion material having a high carrier density.

Further, in the thermoelectric conversion material 11 (the first layer 14 and the second layer 15) of the present embodiment, at least one or both of the first layer 14 and the second layer 15 contains boride, in addition to $Mg_2Si_xSn_{1-x}$ constituting the first layer 14 and $Mg_2Si_ySn_{1-y}$ constituting the second layer 15, where this boride may contain one or two or more metals selected from the group consisting of titanium, zirconium, and hafnium, which are the Group 4 elements. Examples of the above-described boride include $TiB_2$, $ZrB_2$, or $HfB_2$.

Here, in the present embodiment, in a case where the boride is contained, it is preferable that the total amount of the boride is set within a range of 0.5 mass% or more and 15 mass% or less.

Further, the lower limit of the total amount of the boride is more preferably 1 mass% or more and still more preferably 1.5 mass% or more. On the other hand, the upper limit of the total amount of the boride is more preferably 12 mass% or less and still more preferably 10 mass% or less.

Alternatively, in the thermoelectric conversion material 11 (the first layer 14 and the second layer 15) of the present embodiment, at least one or both of the first layer 14 and the second layer 15 may contain aluminum, in addition to $Mg_2Si_xSn_{1-x}$ constituting the first layer 14 and $Mg_2Si_ySn_{1-y}$ constituting the second layer 15.

Here, in the present embodiment, in a case where aluminum is contained, it is preferable that the aluminum content is set within a range of 0.3 mass% or more and 3 mass% or less.

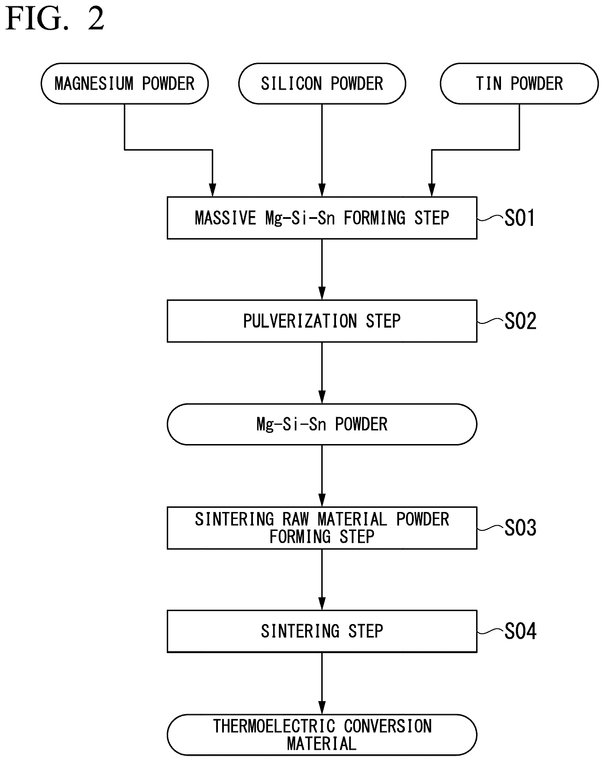

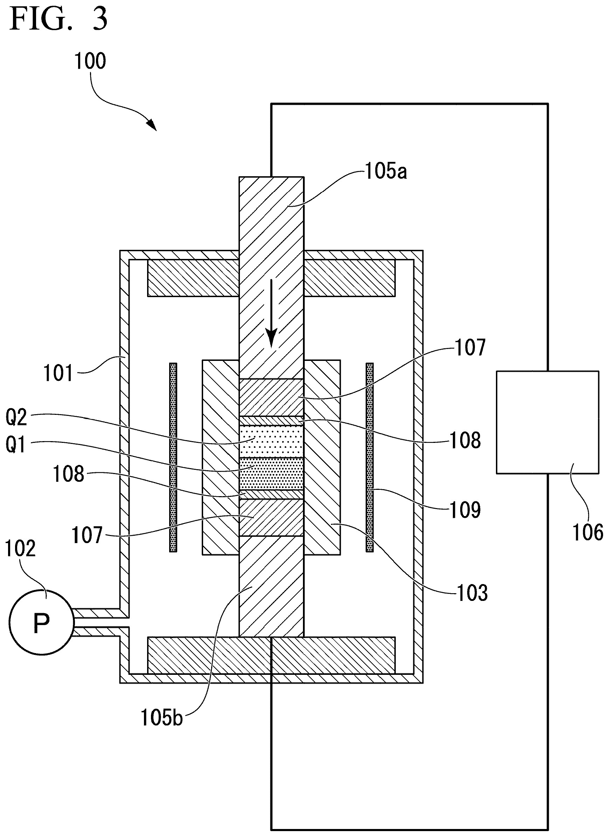

Next, a method for producing the thermoelectric conversion material 11 according to the present embodiment will be described with reference to Fig. 2 and Fig. 3.

(Massive Mg-Si-Sn forming step S01)

First, a first massive Mg-Si-Sn which is the raw material of the first layer 14 ($Mg_2Si_xSn_{1-x}$) of the thermoelectric conversion material 11, and a second massive Mg-Si-Sn which is the raw material of the second layer 15 ($Mg_2Si_ySn_{1-y}$) are produced.

In the present embodiment, each of the magnesium powder, the silicon powder, the tin powder, and the dopant is weighed and mixed, as necessary. For example, a pentavalent material such as antimony or bismuth is mixed as a dopant in a case of forming an n-type thermoelectric conversion material, and a material such as lithium or silver is mixed as a dopant in a case of forming a p-type thermoelectric conversion material. It is noted that non-doped magnesium silicide may be used without adding a dopant.

Then, this mixed powder is introduced into, for example, an alumina crucible, heated to a range of 700°C or higher and 900°C or lower, and then cooled and solidified. As a result, a first massive magnesium silicide as a raw material of the first layer 14 ($Mg_2Si_xSn_{1-x}$) and a second massive magnesium silicide as a raw material of the second layer 15 ($Mg_2Si_ySn_{1-y}$) are obtained.

Since a small amount of magnesium sublimates during heating, it is preferable to add a large amount of magnesium, for example, about 1 at% to 3 at% with respect to the stoichiometric composition of Mg:Si + Sn = 2:1 at the time of weighing the raw material.

(Pulverization step S02)

Next, the obtained first massive Mg-Si-Sn and second massive Mg-Si-Sn are pulverized with a pulverizer to form a first Mg-Si-Sn powder and a second Mg-Si-Sn powder.

In this pulverization step S02, it is preferable that the average particle diameters of the first Mg-Si-Sn powder and the second Mg-Si-Sn powder are set within a range of 1 $\mu$m or more and 100 $\mu$m or less.

It is noted that regarding the first Mg-Si-Sn powder and the second Mg-Si-Sn powder, to which a dopant has been added, the dopant is uniformly present in the first Mg-Si-Sn powder and the second Mg-Si-Sn powder.

(Sintering raw material powder forming step S03)

Next, the obtained first Mg-Si-Sn powder and second Mg-Si-Sn powder are mixed, as necessary, with a boride powder containing one or two or more metals selected from the group consisting of titanium, zirconium, and hafnium, or an aluminum powder, to obtain a first sintering raw material powder Q1 and a second sintering raw material powder Q2.

(Sintering step S04)

Next, the first sintering raw material powder Q1 and the second sintering raw material powder Q2 obtained as described above are heated while being pressurized, to obtain a sintered body.

Here, in the present embodiment, in the sintering step S04, a sintering device (an energized sintering device 100) shown in Fig. 3 is used.

The sintering device (the energized sintering device 100) shown in Fig. 3 includes, for example, a pressure-resistant housing 101; a vacuum pump 102 for depressurizing the inside of the pressure-resistant housing 101; a hollow-shaped carbon mold 103 arranged inside the pressure-resistant housing 101; a pair of electrode parts 105a and 105b that pressurize the sintering raw material powder Q with which the carbon mold 103 is filled, while applying an electric current; and a power supply device 106 that applies a voltage between the pairing electrode parts 105a and 105b. Further, each of the carbon plate 107 and the carbon sheet 108 is arranged between the electrode parts 105a and 105b, and the sintering raw material powder Q. In addition to these, a thermometer (a thermocouple), a displacement meter, and the like are provided, which are not shown in the drawing. Further, in the present embodiment, a heater 109 is disposed on the outer peripheral side of the carbon mold 103. The heaters 109 are arranged on four side surfaces in order to cover the entire outer peripheral surface of the carbon mold 103. As the heater 109, a carbon heater, a nichrome wire heater, a molybdenum heater, a Kanthal wire heater, a high frequency heater, and the like can be used.

In the sintering step S04, first, the carbon mold 103 of the energized sintering device 100 shown in Fig. 3 is filled with the first sintering raw material powder Q1, and the second sintering raw material powder Q2 is stacked on the first sintering raw material powder Q1 used in this filling.

The inside of the carbon mold 103 is covered with, for example, a graphite sheet or a carbon sheet. Then, using the power supply device 106, a direct current is allowed to pass between the pairing electrode parts 105a and 105b to allow a current to flow through the first sintering raw material powder Q1 and the second sintering raw material powder Q2, thereby raising the temperature by self-heating. Further, among the pairing electrode parts 105a and 105b, the moving electrode part 105a is moved toward the first sintering raw material powder Q1 and the second sintering raw material powder Q2, and then the first sintering raw material powder Q1 and the second sintering raw material powder Q2 are pressurized between the moving electrode part 105a and the fixing electrode parts 105b with a predetermined pressure. In addition, the heater 109 is heated.

As a result, the first sintering raw material powder Q1 and the second sintering raw material powder Q2 are sintered as one body by the self-heating of the first sintering raw material powder Q1 and the second sintering raw material powder Q2 and the heat from the heater 109 and by the pressurization, and at the same time, the sintered body of the first sintering raw material powder Q1 is joined to the sintered body of the second sintering raw material powder Q2.

In the present embodiment, the sintering conditions in the sintering step S04 are such that the sintering temperatures of the first sintering raw material powder Q1 and the second sintering raw material powder Q2 are set within a range of 600°C or higher and 800°C or lower, and the holding time at this sintering temperatures is set to 10 minutes or less. Further, the pressurization load is set within a range of 20 MPa or more and 50 MPa or less.

Further, the atmosphere inside the pressure-resistant housing 101 may be an inert atmosphere such as an argon atmosphere or a vacuum atmosphere. In of case of a vacuum atmosphere, the pressure may be 5 Pa or less.

Here, in a case where the sintering temperatures of the first sintering raw material powder Q1 and the second sintering raw material powder Q2 are less than 600°C, the oxide film formed on the surface of the powder of each of the first sintering raw material powder Q1 and the second sintering raw material powder Q2 cannot be sufficiently removed, the surface oxide film of the raw material powder itself remains at the crystal grain boundary, and the binding between the raw material powders is insufficient, which results in a low density of the sintered body. For these reasons, there is a risk that the electric resistance of the obtained thermoelectric conversion material increases. In addition, there is a risk that the mechanical strength of the element may be low due to insufficient binding.

On the other hand, in a case where the sintering temperatures of the first sintering raw material powder Q1 and the second sintering raw material powder Q2 are more than 800°C, there is a risk that the decomposition of Mg-Si-Sn progresses in a short time, a part of Sn and Mg melts and leaks to the outside, causing composition deviation, and the electric resistance increases, and at the same time, the Seebeck coefficient decreases.

Therefore, in the present embodiment, the sintering temperature in the sintering step S04 is set within a range of 600°C or higher and 800°C or lower.

The lower limit of the sintering temperature in the sintering step S04 is preferably 650°C or higher. On the other hand, the upper limit of the sintering temperature in the sintering step S04 is preferably 770°C or lower and more preferably 740°C of lower.

Further, in a case where the holding time at the sintering temperature exceeds 10 minutes, there is a risk that the decomposition of Mg-Si-Sn proceeds, the composition deviates, the electric resistance increases, and at the same time, the Seebeck coefficient decreases. Further, there is a risk that particles become coarse, and the thermal conductivity increase. Therefore, in the present embodiment, the holding time at the sintering temperature in the sintering step S04 is set to 10 minutes or less.

The upper limit of the holding time at the sintering temperature in the sintering step S04 is preferably 5 minutes or less and more preferably 3 minutes or less.

Further, in a case where the pressurization load in the sintering step S04 is less than 20 MPa, there is a risk that the density does not increase, and the electric resistance of the thermoelectric conversion material increase. In addition, there is a risk that the mechanical strength of the element may not increase.

On the other hand, in a case where the pressurization load in the sintering step S04 exceeds 50 MPa, there is a risk that force applied to the carbon jig is large, and thus the jig is cracked.

Therefore, in the present embodiment, the pressurization load in the sintering step S04 is set within a range of 20 MPa or more and 50 MPa or less.

The lower limit of the pressurization load in the sintering step S04 is preferably 23 MPa or more and more preferably 25 MPa or more. On the other hand, the upper limit of the pressurization load in the sintering step S04 is preferably 45 MPa or less and more preferably 40 MPa or less.

By each of the above steps, the thermoelectric conversion material 11 according to the present embodiment is produced.

According to the thermoelectric conversion material 11 according to the present embodiment having such a configuration as described above, by using a thermoelectric conversion material 11 in which the first layer 14 and the second layer 15, having mutually different temperature regions where the thermoelectric characteristics are improved, are directly joined and integrated, the thermoelectric characteristics of the first layer 14 and the second layer 15 are maximized by placing one surface of first layer 14 the high temperature environment and another surface of the second layer 15 in the low temperature environment. As a result, it is possible to significantly improve the thermoelectric power generation output and the thermoelectric power conversion efficiency (power generation efficiency) as compared with a thermoelectric conversion material made of a material having a single composition.

In addition, in thermoelectric conversion material 11 of the present embodiment, a first layer 14 containing $Mg_2Si_xSn_{1-x}$ (here, $0 < x < 1$) is directly joined to a second layer 15 containing $Mg_2Si_ySn_{1-y}$ (here, $0 < y < 1$), where x/y is set within a range of more than 1.0 and less than 2.0. As a result, both the first layer 14 and the second layer 15 are formed of a material system, and the electric resistance and the coefficient of thermal expansion are extremely close to each other. For this reason, it is possible to suppress a decrease in electric resistance, and it is possible to sufficiently improve the power generation efficiency. In addition, the difference in the coefficient of thermal expansion is small, the occurrence of cracking due to the temperature difference can be suppressed, and the stable use is possible.

Further, in the present embodiment, in a case where at least one or both of the first layer 14 and the second layer 15 contain a boride containing one or two or more metals selected from the group consisting of titanium, zirconium, and hafnium, in addition to $Mg_2Si_xSn_{1-x}$ constituting the first layer 14 and $Mg_2Si_ySn_{1-y}$ constituting the second layer 15 are made of an Mg-Si-Sn material, the boride aggregates at the crystal grain boundary of Mg-Si-Sn to improve the electrical conductivity, and it is possible to further improve the power factor (PF), which is one of the indicators of the thermoelectric characteristics, as well as the dimensionless figure of merit (ZT).

Further, since the boride contains one or two or more kinds of metals selected from the group consisting of titanium, zirconium, and hafnium, it is possible to suppress the oxidation of magnesium and improve the oxidation resistance.

Further, since the above-described boride is relatively hard, it is possible to improve the mechanical strength of the thermoelectric conversion material 11.

Here, in a case where the boride is one or two or more borides selected from the group consisting of $TiB_2$, $ZrB_2$, and $HfB_2$, it is possible to reliably improve the thermoelectric characteristics, oxidation resistance, and mechanical strength of the thermoelectric conversion material 11.

Further, in a case where the total amount of the boride is set within a range of 0.5 mass% or more and 15 mass% or less, it is possible to sufficiently improve the thermoelectric characteristics, oxidation resistance, and mechanical strength of the thermoelectric conversion material 11.

Further, in the present embodiment, in a case where at least one or both of the first layer 14 and the second layer 15 contain aluminum, in addition to $Mg_2Si_xSn_{1-x}$ constituting the first layer 14 and $Mg_2Si_ySn_{1-y}$ constituting the second layer 15 are made of an Mg-Si-Sn material, aluminum can suppress the infiltration of oxygen in the atmosphere into the inside of thermoelectric conversion material 11, and the oxidation resistance in a case of being used under high temperature conditions can be reliably improved.

Further, in a case where the amount of aluminum is set within a range of 0.3 mass% or more and 3 mass% or less, the oxidation resistance in a case of being used under high temperature conditions can be reliably improved. Aluminum may be added at the same time as the dopant at the time of producing the raw material particles of $Mg_2Si_xSn_{1-x}$ and $Mg_2Si_ySn_{1-y}$. Further, a boride and aluminum may be added at the same time.

Further, in the thermoelectric conversion element 10 and the thermoelectric conversion module 1 according to the present embodiment, since a thermoelectric conversion material 11 in which the first layer 14 and the second layer 15 having mutually different temperature regions where the thermoelectric characteristics are improved are directly joined, the thermoelectric characteristics of the first layer 14 and the second layer 15 are maximized by, for example, placing one surface (the side opposite to the joining interface) of first layer 14 the high temperature environment and another surface (the side opposite to the joining interface) of the second layer 15 in the low temperature environment, and thus it is possible to significantly improve the thermoelectric power generation output and the thermoelectric power conversion efficiency (power generation efficiency) as compared with a thermoelectric conversion device using the thermoelectric conversion material made of a material having a single composition.

Although the embodiment of the present invention has been described above, the present invention is not limited thereto and can be appropriately modified without departing from the technical idea of the invention.

For example, in the present embodiment, although the description has been made such that a thermoelectric conversion module having a structure as shown in Fig. 1 is constituted, the present embodiment is not limited to this, and in a case where the thermoelectric conversion material of the present invention is used, there are no particular limitations on the structure and arrangement of electrodes or terminals.

Further, in the present embodiment, although the description has been made such that the sintering is carried out using the sintering device (the energized sintering device 100) shown in Fig. 3, the present embodiment is not limited to this, and a method of pressurizing and sintering a sintering raw material while carrying out heating indirectly, for example, hot pressing, hot isotactic pressing (HIP), or the like may be used.

[Examples]

Hereinafter, the results of experiments carried out to confirm the effect of the present invention will be described.

(Example 1)

Each of Mg having a purity of 99.9 mass% (particle diameter: 180 $\mu$m, manufactured by Kojundo Chemical Lab. Co., Ltd.), Si having a purity of 99.99 mass% (particle diameter: 300 $\mu$m, manufactured by Kojundo Chemical Lab. Co., Ltd.), Sn having a purity of 99.99 mass% (particle diameter: 63 $\mu$m, manufactured by Kojundo Chemical Lab. Co., Ltd.), and Sb having a purity of 99.9 mass% (particle diameter: 300 $\mu$m, manufactured by Kojundo Chemical Lab. Co., Ltd.) was weighed. These powders were mixed in a mortar, placed in an alumina crucible, and heated at 750°C for 2 hours in Ar with 5% $H_2$. Considering the deviation from the stoichiometric composition of Mg:Si + Sn = 2:1 due to the sublimation of Mg, Mg was mixed to be more by 1 at% more. As a result, the massive Mg-Si-Sn having the compositions shown in Experimental Examples 1 to 18 in Tables 1 and 2 was obtained.

Next, this massive Mg-Si-Sn was coarsely pulverized with a jaw pulverizer, further pulverized finely with a ball mill, and classified using a sieve shaker to obtain an Mg-Si-Sn powder having an average particle diameter of 30 $\mu$m.

An aluminum powder (purity: 99.99 mass%, particle diameter: 45 $\mu$m) and a boride powder ($TiB_2$) (purity: 99.9 mass%, average particle diameter: 3 $\mu$m)) were prepared as raw materials.

Next, the Mg-Si-Sn powder, the aluminum powder, and the boride powder were mixed in the formulations shown in Experimental Examples 1 to 18 in Tables 1 and 2 to obtain a raw material powder (the Mg-Si-Sn powder is treated as a remainder). It is noted that as will be described below in Experimental Example 14, the aluminum powder may be added at the time of producing the massive Mg-Si-Sn.

These raw material powders were packed in a carbon mold of which the inner side was covered with a carbon sheet, set in the sintering device (the energized sintering device 100) shown in Fig. 3, and then a thermoelectric conversion material was obtained by energized sintering.

Heating was carried out to 500°C under the sintering conditions of vacuum (vacuum degree: 2 Pa or less before the start of sintering), a pressurization pressure of 40 MPa, and a temperature elevation rate of 40 °C/min. The heating was further carried out at a temperature elevation rate of 30 °C/min, and the temperature was held at 700°C for 5 minutes.

First, as Experimental Example, a single-layer thermoelectric conversion material was produced using the single Mg-Si-Sn powder.

Regarding the thermoelectric conversion material obtained as described above, the power factor PF and the dimensionless figure of merit ZT at various temperatures were evaluated. The evaluation results are shown in Table 1 and Table 2.

It is noted that, for example, the description of $Mg_2Si_{0.5}Sn_{0.5}$ (0.5 at% Sb) + 0.06 wt% Al in Experimental Example 13 of Table 1 indicates that a massive Mg-Si-Sn obtained by adding an Sb dopant of a proportion of 0.5 at% to Mg-Si-Sn of Mg:Si:Sn = 2:0.5:0.5 is pulverized, and 0.06 wt% of Al is added thereto at the time of sintering to obtain a thermoelectric conversion material. Similarly, the description of $Mg_2Si_{0.5}Sn_{0.5}$ (0.5 at% Sb, 0.1 at% Al) in Experimental Example 14 indicates it is a thermoelectric conversion material obtained by adding Sb of a proportion of 0.5 at% and Al of 0.1 at% to Mg-Si-Sn of Mg:Si:Sn = 2:0.5:0.5 to obtain a massive Mg-Si-Sn and then pulverizing and sintering the obtained massive Mg-Si-Sn.

The electric resistance value R and the Seebeck coefficient S were measured by ZEM-3 manufactured by ADVANCE RIKO, Inc. The measurement of the electric resistance value R and the Seebeck coefficient S was carried out at 25°C, 50°C, 100°C, 200°C, 300°C, 400°C, and 450°C.

The power factor (PF) was determined according to Expression (1).

$$PF = S^2/R \text{ ... (1)}$$

Here, S: Seebeck coefficient (V/K), R: electric resistance value ($\Omega \cdot$m)

The thermal conductivity $\kappa$ was obtained from, thermal diffusivity $\times$ density $\times$ specific heat capacity. The thermal diffusivity was measured using a thermal constant measuring device (TC-7000 type manufactured by ADVANCE RIKO, Inc.), the density was measured using the Archimedes method, and the specific heat was measured using a differential scanning calorimeter (DSC-7 type, manufactured by PerkinElmer, Inc.). The measurement was carried out at 25°C, 50°C, 100°C, 200°C, 300°C, 400°C, and 450°C.

The dimensionless figure of merit (ZT) was determined according to Expression (2).

$$ZT = S^2\sigma T/\kappa \text{ ... (2)}$$

(Here, T = absolute temperature (K), $\kappa$ = thermal conductivity (W/(m $\times$ K))

[Table 1]

| | | Composition (concentration of dopant in terms of at%) | ZT | | | | | | |
|---|---|---|---|---|---|---|---|---|---|
| | | | 25°C | 50°C | 100°C | 200°C | 300°C | 400°C | 450°C |
| | Example 1 | $Mg_2Si_{0.3}Sn_{0.7}$ (0.5 at%Sb) | 0.09 | 0.11 | 0.15 | 0.23 | 0.31 | 0.32 | - |
| | Example 2 | $Mg_2Si_{0.35}S_{0.65}$ (0.5 at%Sb) | 0.24 | 0.24 | 0.32 | 0.44 | 0.51 | 0.47 | 0.44 |
| | Example 3 | $Mg_2Si_{0.4}Sn_{0.6}$ (0.5 at%Sb) | 0.20 | 0.22 | 0.30 | 0.51 | 0.60 | 0.54 | 0.51 |
| | Example 4 | $Mg_2Si_{0.4}Sn_{0.6}$ (1.0 at%Sb) | 0.21 | 0.23 | 0.30 | 0.52 | 0.59 | 0.53 | 0.51 |
| | Example 5 | $Mg_2Si_{0.45}Sn_{0.65}$ (0.5 at%Sb) | 0.17 | 0.20 | 0.26 | 0.42 | 0.51 | 0.48 | 0.48 |
| | Example 6 | $Mg_2Si_{0.5}Sn_{0.5}$ (0.5 at%Sb) | 0.18 | 0.21 | 0.28 | 0.47 | 0.62 | 0.66 | 0.66 |
| | Example 7 | $Mg_2Si_{0.5}Sn_{0.5}$ (non) | 0.03 | 0.04 | 0.06 | 0.09 | 0.08 | 0.06 | 0.06 |
| | Example 8 | $Mg_2Si_{0.35}Sn_{0.65}$ (0.5 at%Sb) + 3 wt%$TiB_2$ | 0.21 | 0.25 | 0.32 | 0.43 | 0.48 | 0.41 | 0.38 |
| | Example 9 | $Mg_2Si_{0.35}Sn_{0.65}$ (0.5 at%Sb) + 7 wt%$TiB_2$ | 0.17 | 0.19 | 0.25 | 0.30 | 0.34 | 0.35 | 0.32 |
| | Example 10 | $Mg_2Si_{0.4}Sn_{0.6}$ (0.5 at%Sb) + 3 wt%$TiB_2$ | 0.20 | 0.22 | 0.30 | 0.42 | 0.51 | 0.48 | 0.44 |
| | Example 11 | $Mg_2Si_{0.4}Sn_{0.6}$ (0.5 at%Sb) + 7 wt%$TiB_2$ | 0.18 | 0.20 | 0.27 | 0.43 | 0.51 | 0.48 | 0.44 |
| | Example 12 | $Mg_2Si_{0.4}Sn_{0.6}$ (0.5 at%Sb) + 0.3 wt%Al | 0.23 | 0.25 | 0.32 | 0.50 | 0.61 | 0.59 | 0.59 |
| | Example 13 | $Mg_2Si_{0.5}Sn_{0.5}$ (0.5 at%Sb) + 0.06 wt%Al | 0.18 | 0.21 | 0.27 | 0.47 | 0.62 | 0.63 | 0.68 |

(continued)

| | Composition (concentration of dopant in terms of at%) | ZT | | | | | | |
|---|---|---|---|---|---|---|---|---|
| | | 25°C | 50°C | 100°C | 200°C | 300°C | 400°C | 450°C |
| Example 14 | $Mg_2Si_{0.5}Sn_{0.5}$ (0.5 at%Sb, 0.1 at%Al) | 0.19 | 0.22 | 0.29 | 0.46 | 0.60 | 0.62 | 0.65 |
| Example 15 | $Mg_2Si_{0.5}Sn_{0.5}$ (0.5 at%Sb) + 0.32 wt%Al | 0.17 | 0.21 | 0.30 | 0.49 | 0.64 | 0.64 | 0.67 |
| Example 16 | $Mg_2Si_{0.5}Sn_{0.5}$ (0.5 at%Sb) + 1.0 wt%Al | 0.17 | 0.19 | 0.26 | 0.43 | 0.57 | 0.64 | 0.64 |
| Example 17 | $Mg_2Si_{0.5}Sn_{0.5}$ (0.5 at%Sb) + 0.3 wt%Al + 3 wt%TiB$_2$ | 0.19 | 0.20 | 0.28 | 0.47 | 0.65 | 0.69 | 0.70 |
| Example 18 | $Mg_2Si_{0.5}Sn_{0.5}$ (0.5 at%Sb) + 0.3 wt%Al + 7 wt%TiB$_2$ | 0.17 | 0.19 | 0.28 | 0.46 | 0.61 | 0.66 | 0.71 |

[Table 2]

| | Composition (concentration of dopant in terms of at%) | PF | | | | | | |
|---|---|---|---|---|---|---|---|---|
| | | 25°C | 50°C | 100°C | 200°C | 300°C | 400°C | 450°C |
| Example 1 | $Mg_2Si_{0.3}Sn_{0.7}$ (0.5 at%Sb) | 0.765 | 0.883 | 0.951 | 1.119 | 1.209 | 1.229 | - |
| Example 2 | $Mg_2Si_{0.35}Sn_{0.65}$ (0.5 at%Sb) | 1.933 | 1.871 | 1.988 | 2.023 | 1.911 | 1.633 | 1.472 |
| Example 3 | $Mg_2Si_{0.4}Sn_{0.6}$ (0.5 at%Sb) | 1.686 | 1.676 | 1.798 | 1.885 | 1.846 | 1.657 | 1.486 |
| Example 4 | $Mg_2Si_{0.4}Sn_{0.6}$ (1.0 at%Sb) | 1.760 | 1.732 | 1.802 | 1.923 | 1.812 | 1.604 | 1.484 |
| Example 5 | $Mg_2Si_{0.45}Sn_{0.65}$ (0.5 at%Sb) | 1.368 | 1.435 | 1.568 | 1.729 | 1.765 | 1.628 | 1.523 |
| Example 6 | $Mg_2Si_{0.5}Sn_{0.5}$ (0.5 at%Sb) | 1.155 | 1.250 | 1.400 | 1.709 | 1.817 | 1.821 | 1.744 |
| Example 7 | $Mg_2Si_{0.5}Sn_{0.5}$ (non) | 0.211 | 0.241 | 0.299 | 0.313 | 0.219 | 0.176 | 0.161 |
| Example 8 | $Mg_2Si_{0.35}Sn_{0.65}$ (0.5 at%Sb) + 3 wt%TiB$_2$ | 2.027 | 2.003 | 2.096 | 2.136 | 1.972 | 1.628 | 1.418 |
| Example 9 | $Mg_2Si_{0.35}Sn_{0.65}$ (0.5 at%Sb) + 7 wt%TiB$_2$ | 1.811 | 1.816 | 1.936 | 2.020 | 1.901 | 1.661 | 1.452 |
| Example 10 | $Mg_2Si_{0.4}Sn_{0.6}$ (0.5 at%Sb) + 3 wt%TiB$_2$ | 1.779 | 1.743 | 1.907 | 2.026 | 1.973 | 1.751 | 1.563 |
| Example 11 | $Mg_2Si_{0.4}St_{0.6}$ (0.5 at%Sb) + 7 wt%TiB$_2$ | 1.743 | 1.766 | 1.911 | 2.032 | 1.987 | 1.774 | 1.566 |
| Example 12 | $Mg_2Si_{0.4}Sn_{0.6}$ (0.5 at%Sb) + 0.3 wt%Al | 1.822 | 1.758 | 1.874 | 1.982 | 1.970 | 1.821 | 1.702 |
| Example 13 | $Mg_2Si_{0.5}Sn_{0.5}$ (0.5 at%Sb) + 0.06 wt%Al | 1.080 | 1.194 | 1.351 | 1.643 | 1.775 | 1.833 | 1.895 |
| Example 14 | $Mg_2Si_{0.5}Sn_{0.5}$ (0.5 at%Sb, 0.1 at%Al) | 1.293 | 1.368 | 1.483 | 1.727 | 1.821 | 1.837 | 1.808 |
| Example 15 | $Mg_2Si_{0.5}Sn_{0.5}$ (0.5 at%Sb) + 0.32 wt%Al | 1.119 | 1.212 | 1.398 | 1.685 | 1.818 | 1.879 | 1.883 |
| Example 16 | $Mg_2Si_{0.5}Sn_{0.5}$ (0.5 at%Sb) + 1.0 wt%Al | 1.170 | 1.239 | 1.427 | 1.705 | 1.823 | 1.923 | 1.855 |
| Example 17 | $Mg_2Si_{0.5}Sn_{0.5}$ (0.5 at%Sb) + 0.3 wt%Al + 3 wt%TiB$_2$ | 1.273 | 1.262 | 1.464 | 1.783 | 1.978 | 1.991 | 1.940 |

(continued)

| | Composition (concentration of dopant in terms of at%) | PF | | | | | | |
|---|---|---|---|---|---|---|---|---|
| | | 25°C | 50°C | 100°C | 200°C | 300°C | 400°C | 450°C |
| Example 18 | $Mg_2Si_{0.5}Sn_{0.5}$ (0.5 at%Sb) + 0.3 wt%Al + 7 wt%TiB$_2$ | 1.195 | 1.236 | 1.494 | 1.818 | 1.994 | 2.038 | 2.045 |

As shown in Tables 1 and 2, it can be confirmed, from Experimental Examples 1 to 7 in which the proportion of silicon and tin and the dopant concentration are changed, that the temperature range in which the thermoelectric characteristics are good differs depending on the composition. Further, in Experimental Examples 8 to 11 which contain a boride containing one or two or more metals selected from the group consisting of titanium, zirconium, and hafnium, it is confirmed that the power factor (PF) and the dimensionless figure of merit (ZT) are excellent in a relatively low temperature range. Further, in Experimental Examples 12 to 16 which contain aluminum, and Experimental Examples 17 and 18 which contain a boride and aluminum, it is confirmed that the power factor (PF) and the dimensionless figure of merit (ZT) are excellent in a relatively high temperature range.

(Example 2)

With reference to the evaluations in Table 1 and Table 2, Two kinds of Mg-Si-Sn powders were selected as a composition of the thermoelectric conversion material having good characteristics on the high temperature side for the first layer, and a composition having good characteristics on the low temperature side for the second layer.

These raw material powders were packed in a carbon mold of which the inside was covered with a carbon sheet and set in the sintering device (the energized sintering device 100) shown in Fig. 3, and a thermoelectric conversion material having a structure in which the $Mg_2Si_xSn_{1-x}$ sintered body for the first layer is joined to the $Mg_2Si_ySn_{1-y}$ sintered body for the second layer was obtained by energized sintering.

It is noted that heating was carried out to 500°C under the sintering conditions of vacuum (2 Pa), a pressurization pressure of 40 MPa, and a temperature elevation rate of 40 °C/min. The heating was further carried out at a temperature elevation rate of 30 °C/min, and the temperature was held at 700°C for 5 minutes.

For example, a thermoelectric conversion material having the composition of Experimental Example 6 for the first layer and the composition of Experimental Example 3 for the second layer was prepared and used as Present Invention Example 1.

Further, a thermoelectric conversion material having the compositions for the first layer and the second layer shown in Table 3 was obtained.

The power generation characteristics were measured as follows. A sample of 6 mm × 6 mm × 10 mm, in which the first layer was directly joined to the second layer and integrated, a heating block (the high temperature side), a heat flux block (the low temperature side, a chiller set at 35°C was used), two Ag electrode plates, and two AlN plates were prepared, and they were arranged from the bottom, in the following order; the heat flux block, the AlN plate, the Ag electrode, the sample, the Ag electrode, the AlN plate, and the heating block. A terminal for measuring voltage and a terminal for measuring current were each attached to the Ag electrode plates at the upper and lower ends. The device used for the voltage/current measurement is a 6242 DC voltage current source/monitor manufactured by ADC Corporation.

The heating block and the heat flow block were held with a constant load of 200 N with the sample being sandwiched, and the temperature of the heating block on the high temperature side was set to 55°C, 100°C, 205°C, 300°C, and 395°C. The temperature differences ($\Delta T$) were each 20°C, 66°C, 170°C, 260°C, and 355°C.

The temperature of the heating block was set to a predetermined temperature, and the open-circuit voltage was measured when the temperatures of the heating block and the heat flux block were stable. Next, a reverse current is allowed to flow, and the current value (the maximum current, the short-circuit current) at which the voltage becomes zero is measured using a direct voltage/current source/monitor. The maximum output was determined from the open-circuit voltage and the maximum current at each temperature, and further, it was replaced with the maximum output per unit area.

Table 4 shows the power generation characteristics of the sample in which a first layer containing 14 $Mg_2Si_xSn_{1-x}$ (here, 0 < x < 1) is directly joined to a second layer 15 containing $Mg_2Si_ySn_{1-y}$ (here, 0 < y < 1).

[Table 3]

| | Thermoelectric conversion material | | |
| --- | --- | --- | --- |
| | First layer | Second layer | x/y |
| Present Invention Example 1 | $Mg_2Si_{0.5}Sn_{0.5}$ (0.5 at%Sb) Example 6 | $Mg_2Si_{0.4}Sn_{0.6}$ (0.5 at%Sb) Example 3 | 1.25 |
| Present Invention Example 2 | $Mg_2Si_{0.5}Sn_{0.5}$ (0.5 at%Sb) Example 6 | $Mg_2Si_{0.35}Sn_{0.65}$ (0.5 at%Sb) Example 2 | 1.43 |
| Present Invention Example 3 | $Mg_2Si_{0.55}Sn_{0.45}$ (0.5 at%Sb) | $Mg_2Si_{0.32}Sn_{0.68}$ (0.5 at%Sb) | 1.72 |
| Present Invention Example 4 | $Mg_2Si_{0.5}Sn_{0.5}$ (0.5 at%Sb) + 3 wt%TiB$_2$ | $Mg_2Si_{0.4}Sn_{0.6}$ (0.5 at%Sb) + 3 wt%TiB$_2$ Example 10 | 1.25 |
| Present Invention Example 5 | $Mg_2Si_{0.5}Sn_{0.5}$ (0.5 at%Sb) + 0.3 wt%Al + 3 wt%TiB$_2$ Example 17 | $Mg_2Sio._4Sti_{0.6}$ (0.5 at%Sb) + 0.3 wt%Al + 3 wt%TiB$_2$ | 1.25 |
| Comparative Example 1 | $Mg_2Si_{0.4}Sn_{0.6}$ (0.5 at%Sb) Example 3 | $Mg_2Si_{0.5}Sn_{0.5}$ (0.5 at%Sb) Example 6 | 0.8 |
| Comparative Example 2 | $Mg_2Si_{0.6}Sn_{0.4}$ (0.5 at%Sb) | $Mg_2Si_{0.3}Sn_{0.7}$ (0.5 at%Sb) Example 1 | 2 |

[Table 4]

| | Evaluation of thermoelectric power generation characteristics | | | | | |
| --- | --- | --- | --- | --- | --- | --- |
| | Evaluation item | 20°C | 66°C | 170°C | 260°C | 355°C |
| Present Invention Example 1 | Open-circuit voltage(mV) | 6.94 | 20.30 | 52.49 | 82.74 | 110.84 |
| | Maximum output (mW/cm$^2$) | 0.35 | 3.32 | 27.32 | 80.36 | 170.50 |
| Present Invention Example 2 | Open-circuit voltage (mV) | 7.39 | 21.28 | 54.16 | 82.87 | 119.75 |
| | Maximum output (mW/cm$^2$) | 0.40 | 3.67 | 29.32 | 83.19 | 187.37 |
| Present Invention Example 3 | Open-circuit voltage (mV) | 6.53 | 19.01 | 50.38 | 77.21 | 103.59 |
| | Maximum output (mW/cm$^2$) | 0.30 | 3.00 | 23.72 | 74.40 | 166.80 |
| Present Invention Example 4 | Open-circuit voltage (mV) | 7.05 | 20.38 | 56.27 | 81.50 | 107.43 |
| | Maximum output (mW/cm$^2$) | 0.37 | 3.52 | 29.37 | 85.89 | 186.41 |
| Present Invention Example 5 | Open-circuit voltage (mV) | 7.41 | 21.68 | 55.54 | 85.60 | 112.30 |
| | Maximum output (mW/cm$^2$) | 0.42 | 3.97 | 31.85 | 91.06 | 204.86 |
| Comparative Example 1 | Open-circuit voltage (mV) | 6.18 | 17.75 | 48.60 | 74.63 | 99.47 |
| | Maximum output (mW/cm$^2$) | 0.28 | 2.79 | 22.85 | 70.55 | 162.20 |
| Comparative Example 2 | Open-circuit voltage | 9.98 | 26.48 | 58.74 | 76.44 | 91.87 |
| | Maximum output (mW/cm$^2$) | 0.16 | 1.75 | 14.46 | 48.48 | 111.66 |

As shown in Tables 3 and 4, it can be confirmed that Present Invention Examples 1 to 5, in which a first layer containing $Mg_2Si_xSn_{1-x}$ (here, 0 < x < 1) is directly joined to a second layer containing $Mg_2Si_ySn_{1-y}$ (here, 0 < y < 1), where x/y is set within a range of more than 1.0 and less than 2.0, have excellent power generation characteristics as compared with Comparative Examples 21 and 22 in which x/y is set to outside a range of more than 1.0 and less than 2.0.

In particular, it can be confirmed that in a case where x/y is less than 1, the characteristics are decreased as a whole since a material having excellent characteristics in the high temperature region is used on the low temperature side, and a material having excellent characteristics in the low temperature region is used on the high temperature side. Further, it can be confirmed that in a case where x/y is 2 or more, the thermoelectric characteristics are decreased as a whole since the characteristics of the second layer (the low temperature side) are decreased.

From the results of the above examples, it was confirmed that according to the Present Invention Examples, it is possible to provide a thermoelectric conversion material, a thermoelectric conversion element, and a thermoelectric conversion module.

Reference Signs List

1 Thermoelectric conversion module
10 Thermoelectric conversion element
11 Thermoelectric conversion material
14 First layer
15 Second layer
18a, 18b Electrode
19a, 19b Terminal

**Claims**

1. A thermoelectric conversion material,

   wherein a first layer containing $Mg_2Si_xSn_{1-x}$ (here, $0 < x < 1$) is directly joined to a second layer containing $Mg_2Si_ySn_{1-y}$ (here, $0 < y < 1$), and
   x/y is set within a range of more than 1.0 and less than 2.0.

2. The thermoelectric conversion material according to Claim 1,

   wherein in addition to $Mg_2Si_xSn_{1-x}$ constituting the first layer and $Mg_2Si_ySn_{1-y}$ constituting the second layer, at least one or both of the first layer and the second layer contains boride, and
   the boride contains one or two or more metals selected from a group consisting of titanium, zirconium, and hafnium.

3. The thermoelectric conversion material according to Claim 2,
   wherein the boride is one of two or more borides selected from a group consisting of $TiB_2$, $ZrB_2$, and $HfB_2$.

4. The thermoelectric conversion material according to Claim 2 or 3,
   wherein a total amount of the boride is set within a range of 0.5 mass% or more and 15 mass% or less.

5. The thermoelectric conversion material according to any one of Claims 1 to 4,
   wherein in addition to $Mg_2Si_xSn_{1-x}$ constituting the first layer and $Mg_2Si_ySn_{1-y}$ constituting the second layer, at least one or both of the first layer and the second layer contains aluminum.

6. The thermoelectric conversion material according to Claim 5,
   wherein an amount of the aluminum is set within a range of 0.3 mass% or more and 3 mass% or less.

7. A thermoelectric conversion element comprising:

   the thermoelectric conversion material according to any one of Claims 1 to 6; and
   electrodes each joined to one surface and an other surface of the thermoelectric conversion material.

8. A thermoelectric conversion module comprising:

the thermoelectric conversion element according to Claim 7; and
terminals each joined to the electrodes of the thermoelectric conversion element.

FIG. 1

# FIG. 2

```
MAGNESIUM POWDER          SILICON POWDER           TIN POWDER
         │                      │                      │
         └──────────┐          │          ┌───────────┘
                    ▼          ▼          ▼
         ┌─────────────────────────────────────┐
         │   MASSIVE Mg-Si-Sn FORMING STEP     │───S01
         └─────────────────────────────────────┘
                            │
                            ▼
         ┌─────────────────────────────────────┐
         │         PULVERIZATION STEP          │───S02
         └─────────────────────────────────────┘
                            │
                            ▼
         ┌─────────────────────────────────────┐
         │         Mg-Si-Sn POWDER             │
         └─────────────────────────────────────┘
                            │
                            ▼
         ┌─────────────────────────────────────┐
         │  SINTERING RAW MATERIAL POWDER      │───S03
         │         FORMING STEP                │
         └─────────────────────────────────────┘
                            │
                            ▼
         ┌─────────────────────────────────────┐
         │          SINTERING STEP             │───S04
         └─────────────────────────────────────┘
                            │
                            ▼
         ┌─────────────────────────────────────┐
         │   THERMOELECTRIC CONVERSION         │
         │          MATERIAL                   │
         └─────────────────────────────────────┘
```

# FIG. 3

## INTERNATIONAL SEARCH REPORT

International application No.

PCT/JP2021/009217

### A. CLASSIFICATION OF SUBJECT MATTER

H01L 35/14(2006.01)i; C01B 33/06(2006.01)i; H01L 35/22(2006.01)i; H01L 35/26(2006.01)i

FI: H01L35/14; C01B33/06; H01L35/22; H01L35/26

According to International Patent Classification (IPC) or to both national classification and IPC

### B. FIELDS SEARCHED

Minimum documentation searched (classification system followed by classification symbols)

H01L35/14; C01B33/06; H01L35/22; H01L35/26

Documentation searched other than minimum documentation to the extent that such documents are included in the fields searched

| | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2019-012828 A (MITSUBISHI MATERIALS CORP.) 24 January 2019 (2019-01-24) paragraphs [0107]-[0120], fig. 10 | 1, 5–8<br>2–4 |
| Y | JP 2016-164960 A (MITSUBISHI CHEMICAL CORP.) 08 September 2016 (2016-09-08) paragraphs [0008], [0011]-[0029], [0035] | 2–4 |

☐ Further documents are listed in the continuation of Box C.　　☒ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 28 May 2021 (28.05.2021) | 08 June 2021 (08.06.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

INTERNATIONAL SEARCH REPORT

Information on patent family members

International application No.

PCT/JP2021/009217

| Patent Documents referred in the Report | Publication Date | Patent Family | Publication Date |
|---|---|---|---|
| JP 2019-012828 A | 24 Jan. 2019 | US 2020/0044131 A1 paragraphs [0215]-[0246], fig. 10 WO 2019/004373 A1 EP 3648185 A1 TW 201904915 A CN 110366784 A KR 10-2020-0024749 A | |
| JP 2016-164960 A | 08 Sep. 2016 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020045332 A
- JP 2012533972 W
- JP 2017175122 A